# EUROPEAN PATENT SPECIFICATION

(11) **EP 2 994 946 B1**
(45) Date of publication and mention of the grant of the patent: **04.07.2018**
(21) Application number: 14730176.6
(22) Date of filing: 30.04.2014
(51) Int. Cl.: H01L 51/42, H01L 51/00

(54) **METHOD OF MANUFACTURING PHOTOVOLTAIC DEVICE USING PEROVSKITES**
VERFAHREN ZUR HERSTELLUNG EINER FOTOVOLTAIKVORRICHTUNG MITHILFE VON PEROWSKITEN
PROCÉDÉ DE FABRICATION D'UN DISPOSITIF PHOTOVOLTAÏQUE UTILISANT DES PÉROVSKITES

(30) Priority: 06.05.2013 GB 201308135; 28.05.2013 GB 201309517
(43) Date of publication of application: 16.03.2016
(73) Proprietor: Swansea University, Swansea SA2 8PP (GB)
(72) Inventor: CHARBONNEAU, Cecile, Swansea SA2 8PP (GB); CARNIE, Matthew, Swansea SA2 8PP (GB)
(74) Representative: Fyles, Julie Marie
(86) International application number: PCT/GB2014/000166
(87) International publication number: WO 2014/181072

(56) References cited:
- JAMES M. BALL ET AL: "Low-temperature processed meso-superstructured to thin-film perovskite solar cells", ENERGY & ENVIRONMENTAL SCIENCE, vol. 6, no. 6, 28 March 2013 (2013-03-28), page 1739, XP055114910, ISSN: 1754-5692, DOI: 10.1039/c3ee40810h
- M. M. LEE ET AL: "Efficient Hybrid Solar Cells Based on Meso-Superstructured Organometal Halide Perovskites", SCIENCE, vol. 338, no. 6107, 4 October 2012 (2012-10-04), pages 643-647, XP055071972, ISSN: 0036-8075, DOI: 10.1126/science.1228604
- N.A.: "Trocknungsmittel", , 17 August 2016 (2016-08-17), XP055295855, Retrieved from the Internet: URL:http://web.hs-merseburg.de/~ag-vt/ADS_ Trocknungsmittel.pdf [retrieved on 2016-08-17]

## Description

### Field of the Invention

The invention relates to a method of manufacturing a photovoltaic device based upon using perovskites.

### Background of the Invention

An efficient solar cell must absorb over a broad spectral range, from visible to near-infrared (near-IR) wavelengths (350 to -950 nm), and convert the incident light effectively into charges. The charges must be collected at a high voltage with suitable current in order to do useful work. A simple measure of solar cell effectiveness at generating voltage is the difference in energy between the optical band gap of the absorber and the open-circuit voltage (*V*_{oc}) generated by the solar cell under simulated air mass (AM) 1.5 solar illumination of 100 mW cm⁻².

Dye-sensitized solar cells (DSSCs) have losses, both from electron transfer from the dye (or absorber) into the Ti0₂, which requires a certain "driving force," and from dye regeneration from the electrolyte, which requires an over potential. Efforts have been made to reduce such losses in DSSCs.

Inorganic semiconductor-sensitized solar cells have recently been used where a thin absorber layer of 2 to 10 nm in thickness, is coated upon the internal surface of a mesoporous TiO₂ electrode and then contacted with an electrolyte or solid-state hole conductor. These devices have achieved power conversion efficiencies of up to 6.3% However, in such systems there are low open circuit voltages which may be a result of the electronically disordered, low-mobility n- type TiO₂.

Perovskites are relatively underexplored in the area of solar cells and they provide a framework for binding organic and inorganic components into a molecular composite. It has been shown that layered perovskites based on organometal halides demonstrate excellent performance as light-emitting diodes and transistors with mobilities comparable to amorphous silicon.

The manufacture of solar cells based upon perovskites has several procedural steps which increases manufacturing costs because the process takes more time and energy. Typically the process involves providing a glass substrate having a conductive coating; usually fluorine doped tin oxide (FTO,) on one surface of the substrate. The FTO layer is coated with TiO₂, a sintered layer of metal oxide nanoparticles is coated on the TiO₂ and then there is heat treatment to drive off binders etc. to form a nanoporous film. The nanoporous film is coated with a precursor including a perovskite that again is heat treated so that the solution crystallizes to form a solid perovskite light absorber and electron transporter. As a final stage a hole transport layer and metal contacts are added.

Low-temperature processed meso-structured thin film perovskite solar cells are disclosed in Energy Environ. Sci., 2013, 6, pp. 1739-1743. These solar cells are prepared via a multiple step process as indicated above, in which a meso-structured scaffold for charge transfer is prepared, followed by drying, cooling and subsequent deposition of a perovskite precursor, which is then heated to form the perovskite.

The use of sintering to drive off binders etc. means that considerable time is taken to process the structure and also there is the increased cost of heating. The present invention seeks to overcome the problems of the prior art by providing a rapid and low temperature process in an extremely efficient photovoltaic device.

### Summary of the Invention

According to the present invention there is provided a method of making a photovoltaic device as defined in claim 1.

Preferably the compact layer is a metal oxide and in particular a dioxide.

It is preferred that the substrate is a layer of glass. However other materials such as metal or plastic may be used.

It is envisaged that the substrate has a coating of a transparent conducting oxide, which is typically fluorine doped tin oxide.

It is preferred that the dioxide layer is titanium dioxide.

Preferably the dioxide layer is applied by spray pyrolysis or spin coating a precursor solution followed by heat treatment.

It is envisaged that the metal oxide nanoparticles are selected from one or more of titania, alumina or zirconia. In particular the nanoparticles are Al₂O₃.

It is preferred that the perovskite precursor is an organometal halide. Typically the organometal halide is of the structure ABX₃ where A and B are cations and X represents anions.

Preferably the percentage of metal oxide nanoparticles in the precursor solution containing the perovskite precursor is 1 to 15% more preferable 1.5 to 12% and more particularly 2-7%.

It is envisaged that the perovskite precursor solution is heat treated at a temperature of up to 200 degrees centigrade, more preferably 150 degrees centigrade and even more preferably between 100 and 120 degrees centigrade. The heating crystallizes the perovskite precursor to form the scaffold.

The compact layer and the coating may be provided as a single integral layer.

### Brief Description of the Drawings

An embodiment of the present invention are described in more detail below, by way of illustrative example only, in conjunction with the accompanying figures, of which:
Figure 1 shows: (A): a schematic representation of perovskite structure ABX₃ (A = CH₃NH₃, B = Pb, and X = Cl, I). (B) an SEM (scanning electron micrograph) view of a perovskite unit cell;
Figure 2 shows: performance data of solutions where nanoparticles are in the precursor solution;
Figure 3 shows: a scanning electron micrograph (SEM) of a plan view of a spin coated layer which has been heat treated and where alumina rich and poor areas are shown: and
Figure 4 shows: a cross sectional SEM of a device coated with 5% by weight of nanoparticles in a perovskite precursor.

### Detailed Description of the Invention

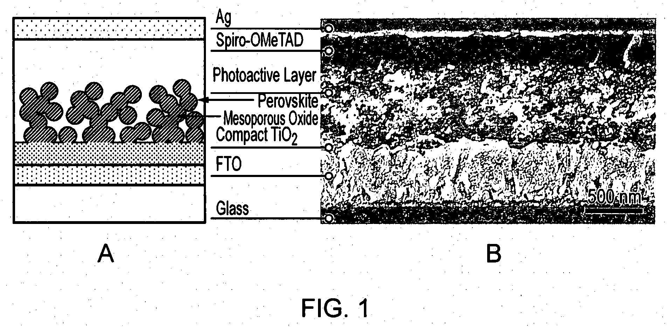

As can be seen in Figure 1, solar cells were fabricated where a glass substrate is coated with a semitransparent fluorine-doped tin oxide (FTO). A compact layer of TiO₂ is then added and this acts as an anode. If glass is used the doped layer may be fluorine doped tin oxide on glass or indium tin oxide, which also may be provided on a plastic (e.g. PET or PEN) rather than glass.

The compact layer may be applied to the glass in the form of a paste comprising a metal oxide in a binder and a solvent so that the oxide can be printed on a surface. The metal may also be a wide band gap metal oxide such as SnO₂ or ZnO or TiO₂. An advantage of SnO₂ is that it is easier to obtain good particle interconnectivity which will minimise resistive losses and increase the efficiency of the sensitized solar cell. An advantage of using ZnO is that ZnO nanoparticles are readily available at low material cost. There are however, several advantages that are associated with using TiO₂, namely, TiO₂ is readily available, cheap, none-toxic and possesses good stability under visible radiation in solution, and an extremely high surface area suitable for dye adsorption. TiO₂ is also porous enough to allow good penetration by the electrolyte ions, and finally, TiO₂ scatters incident photons effectively to increase light harvesting efficiency.

The next layer that is added is the photoactive layer which includes nanoparticles and a perovskite precursor. Electron injection into the anode (typically TiO₂) layer occurs and electron transport occurs through the titania film. When a non-conducting metal oxide is used, transport occurs through the perovskite material itself to the anode electrode, with the metal oxide nanoparticles acting as a scaffold to support the perovskite material. The nano-particles are placed directly in the organometal halide perovskite precursor solution prior to coating and both materials are laid down together. This precursor solution is heated at a much lower temperature than in known systems and by eliminating this high temperature step that the usual manufacturing processes use then the manufacture of these devices will be faster than those that are known. The process also uses less energy as the two usual heating steps namely sintering to drive of solvents and binders (500°C) and then crystallizing the perovskite. (100°C) are now combined into one heating step, typically at 100°C. This single step heating is unusual in that it still results in a scaffold with electron transfer properties.

The nano-particles are sold as a suspension either in water or IPA (isopropyl alcohol). These solvent are often incompatible with the perovskite precursor solution and so the nanoparticles should be suspended in the same solvent as the perovskite precursor solution. This is achieved via solvent exchange in a rotary evaporator. The preferred solvents for the organometal halide perovskite precursor solution are either DMF (N,N-Dimethylformamide) or *y*-butyrolactone. The precursor then consists of primary amine halide salt e.g. CH₃NH₃I (methyl ammonium lead iodide) and a lead halide salt e.g. PbCl₂ (lead chloride) dissolved in the solvent in the correct stoichiometry.
To complete the photoactive layer, the perovskite-coated porous electrode was further filled with the hole transporter, spiro-OMeTAD, via spin-coating and the spiro-OMeTAD forms a capping layer that ensures selective collection of holes at the silver electrode.

It is envisaged that this process will not be limited by substrate type so that devices will be manufacturable on glass or metal substrates. In addition, because of the low temperature nature of the process we envisage it possible to manufacture devices on plastic substrates.

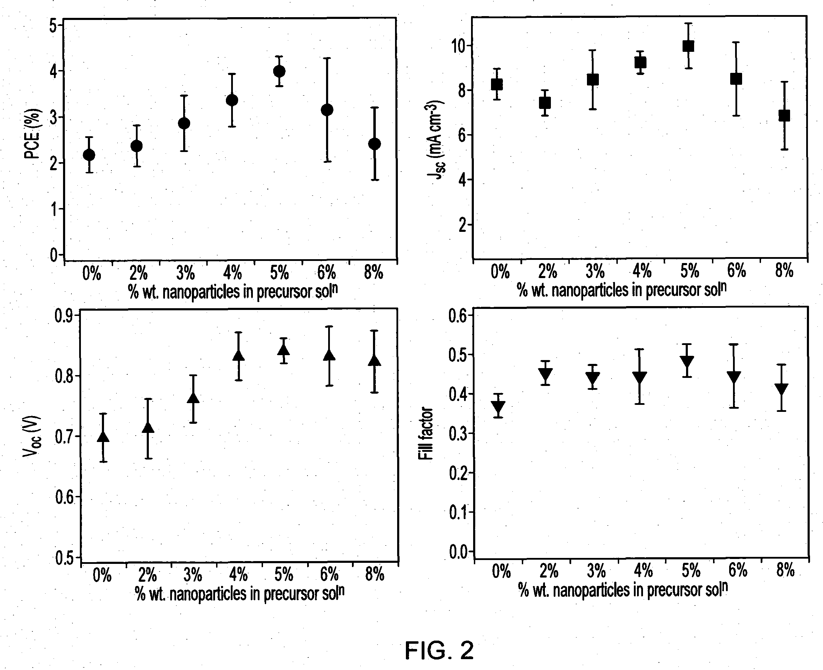

As shown in Figure 2, the level of loading of the precursor with the nanoparticles has an impact on the efficiency of the device. A good performance is achieved when the precursor has a nanoparticle loading of 5% by weight and performance rises up to this level and declines afterwards. Further with this level of loading the efficiency of the devices formed is more consistent.

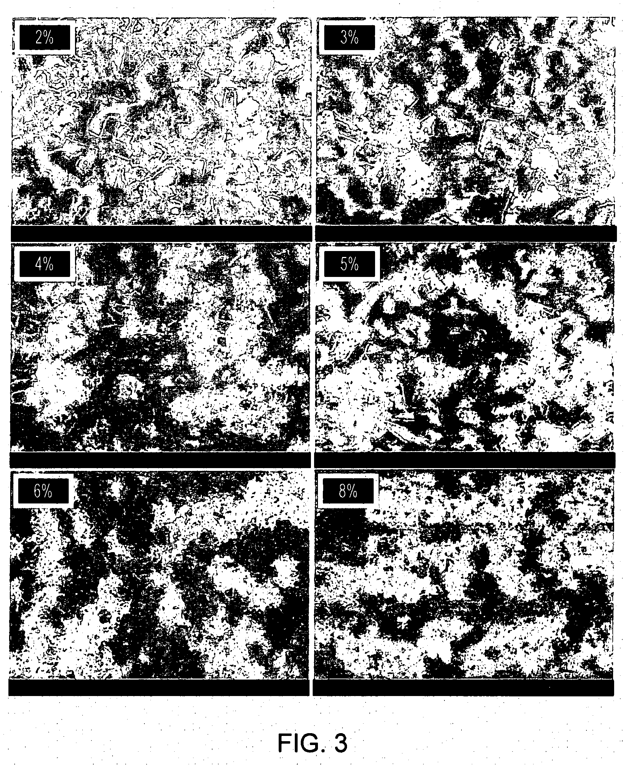

Figure 3 shows a series of electron micrographs of where a mesoporous layer having nanoparticles, such as Al₂O₃- in a perovskite suspension has been sued. The perovskite suspension is CH₃NH₃Pbl₂Cl. As can be seen the film formed is no homogenous with there being A1 rich areas (light colouration) and A1 poor regions (dark colouration). The separate images show the perovskite solution where there are nanoparticles in varying quantities and the precursor is applied directly onto the compact TiO₂ by spin coating and is then heat treated at 100 degrees centigrade.

For Al₂O₃-based cells, the electrons should remain in the perovskite phase until they are collected at the planar TiO₂-coated FTO electrode, and must hence are transported throughout the film thickness in the perovskite. The perovskite layer functions as both absorber and n-type component, transporting electronic charge out of the device with electrons being transferred to the TiO₂ (with subsequent electron transport to the FTO electrode through the TiO₂) and holes would be transferred to the spiro-OMeTAD (with subsequent transport to the silver electrode).

Typically charge collection in Al₂O₃-based devices was faster than in the TiO₂-based sensitized devices by a factor of >10, indicating faster electron diffusion through the perovskite phase than through the n-type TiO₂. Perovskites tend to form layered structures, with continuous two-dimensional metal halide planes perpendicular to the z axis and the lower dielectric organic components (methyl amine) between these planes. This quasi-two-dimensional confinement of the excitons can result in an increased exciton binding energy, which can be up to a few hundred millielectron volts.

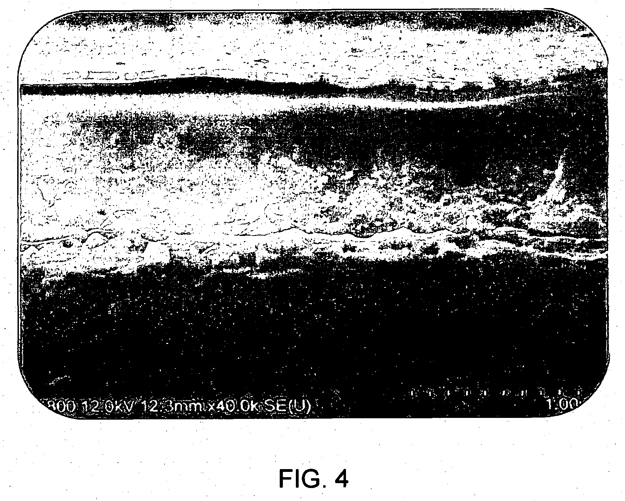

The application of a mesostructured insulating scaffold upon which extremely thin films of n- type and p-type semiconductors are assembled, termed the meso-superstructured solar cell (MSSC), has proven to be extraordinarily effective with an n-type perovskite. The light absorption near the band edge can be enhanced through carefully engineered mesostructures and by optimising the nanoparticle to perovskite ratio. As shown in Figure 4, the loading of the perovskite precursor with a certain level of nanoparticles provides and optimised scaffold having a maximized surface area so that photovoltaic properties can be exploited as planar junction devices having efficiencies of around 1.8%. Also because a low temperature process can be used, it is envisaged that the precursor can be simply painted onto a substrate and heat treated in situ to provide the solid perovskite light absorber and transporter.

The invention has particular benefits in that it avoids having to use an expensive and time consuming processing step of sintering, typically at 500 degree centigrade. In this invention it allows for dilute solutions to be coated, typically spin coated onto a porous matrix e.g. Al₂O₃. The matrix may be in the form of a film which when heated at lower temperatures e.g. 120 degrees centigrade forms a framework as a result of evaporation of solvent and nucleation of perovskite. The perovskite grows into a continuous network so forming a scaffold for the solar cell and so provides a rapid and cost effective way of manufacturing solar cells.

## Claims

1. A method of making a photovoltaic device the method including: providing a substrate;
forming a compact layer on the substrate;
**characterised in that** the compact layer is coated with a precursor solution including metal oxide nanoparticles and a perovskite precursor and said precursor solution is heated to form a scaffold having a perovskite light absorber and electron transporter therein, following which a hole conductor is added to form a connection with the scaffold.

2. A method according to claim 1, wherein the substrate is a layer of glass, metal or plastic or a mixture thereof.

3. A method according to claim 1 or claim 2, wherein the substrate is coated with a transparent conducting oxide which typically is fluorine doped tin oxide.

4. A method according to any preceding claim wherein the compact layer is a metal oxide.

5. A method according to claim 4, wherein the metal oxide is titanium dioxide.

6. A method according to claim 4 or claim 5, wherein the metal oxide layer is applied by spray pyrolysis or spin coating a precursor solution followed by heat treatment.

7. A method according to claim 1 and any preceding claim when dependent on claim 1, wherein the metal oxide nanoparticles are selected from one or more of an oxide of titania, alumina or zirconia.

8. A method according to claim 7, wherein the metal oxide is Al₂O₃.

9. A method according to any preceding claim wherein the perovskite precursor is an organometal halide.

10. A method according to any preceding claim wherein the percentage of metal oxide nanoparticles in the precursor solution containing the perovskite precursor is 1 to 15% more preferable 1.5 to 12% and more particularly 2-7%.

11. A method according to any preceding claim wherein once laid down on a dioxide layer, the precursor solution is heat treated at a temperature of up to 200 degrees centigrade, more preferably 150 degrees centigrade and even more preferably between 100 and 120 degrees centigrade.

12. A method according to any preceding claim wherein the compact layer and the coating are provided as a single integral layer.

## Patentansprüche

1. Verfahren zur Herstellung einer Fotovoltaikvorrichtung, wobei das Verfahren Folgendes einschließt: Bereitstellen eines Substrats;
Bilden einer kompakten Schicht auf dem Substrat;
**dadurch gekennzeichnet, dass** die kompakte Schicht mit einer Vorläuferlösung, einschließend Metalloxidnanopartikel und einen Perowskitvorläufer, beschichtet ist und die Vorläuferlösung erwärmt wird, um ein Gerüst zu bilden, das darin einen Perowskit-Lichtabsorber und-Elektronenüberträger aufweist, wonach ein Lochleiter hinzugegeben wird, um eine Verbindung zu dem Gerüst zu bilden.

2. Verfahren nach Anspruch 1, wobei das Substrat einer Schicht aus Glas, Metall oder Kunststoff oder einem Gemisch davon entspricht.

3. Verfahren nach Anspruch 1 oder Anspruch 2, wobei das Substrat mit einem transparenten leitfähigen Oxid beschichtet ist, welches üblicherweise mit Fluor dotiertes Zinnoxid ist.

4. Verfahren nach einem der vorhergehenden Ansprüche, wobei die kompakte Schicht einem Metalloxid entspricht.

5. Verfahren nach Anspruch 4, wobei das Metalloxid Titandioxid ist.

6. Verfahren nach Anspruch 4 oder Anspruch 5, wobei die Metalloxidschicht durch eine Sprühpyrolyse oder Rotationsbeschichtung einer Vorläuferlösung, gefolgt von einer Wärmebehandlung, aufgebracht wird.

7. Verfahren nach Anspruch 1 und einem vorhergehenden Anspruch, wenn abhängig von Anspruch 1, wobei die Metalloxidnanopartikel ausgewählt sind aus einem oder mehreren von einem Oxid von Titanoxid, Aluminiumoxid oder Zirconiumoxid.

8. Verfahren nach Anspruch 7, wobei das Metalloxid Al₂O₃ ist.

9. Verfahren nach einem der vorhergehenden Ansprüche, wobei der Perowskitvorläufer ein metallorganisches Halogenid ist.

10. Verfahren nach einem der vorhergehenden Ansprüche, wobei der prozentuale Anteil von Metalloxidnanopartikeln in der Vorläuferlösung, die den Perowskitvorläufer enthält, von 1 bis 15 %, vorzugsweiser 1,5-12 % und insbesondere 2-7 % reicht.

11. Verfahren nach einem der vorhergehenden Ansprüche, wobei die Vorläuferlösung, sobald sie auf einer Dioxidschicht ausgelegt wurde, bei einer Temperatur von bis zu 200 Grad Celsius, vorzugsweiser 150 Grad Celsius und sogar noch vorzugsweiser zwischen 100 und 120 Grad Celsius wärmebehandelt wird.

12. Verfahren nach einem der vorhergehenden Ansprüche, wobei die kompakte Schicht und die Beschichtung als eine einzige einstückige Schicht bereitgestellt sind.

## Revendications

1. Procédé de fabrication d'un dispositif photovoltaïque le procédé comprenant : la fourniture d'un substrat ;
la formation d'une couche compacte sur le substrat ; **caractérisé en ce que** la couche compacte est revêtue d'une solution de précurseur comprenant des nanoparticules d'oxyde métallique et un précurseur de pérovskite et ladite solution de précurseur est chauffée pour former un échafaudage ayant un absorbeur de lumière de pérovskite et un transporteur d'électrons dans celui-ci, après quoi un conducteur de trou est ajouté pour former une liaison avec l'échafaudage.

2. Procédé selon la revendication 1, dans lequel le substrat est une couche de verre, métal ou plastique ou un mélange de ceux-ci.

3. Procédé selon la revendication 1 ou la revendication 2, dans lequel le substrat est revêtu d'un oxyde conducteur transparent qui est typiquement de l'oxyde d'étain dopé au fluor.

4. Procédé selon une quelconque revendication précédente dans lequel la couche compacte est un oxyde métallique.

5. Procédé selon la revendication 4, dans lequel l'oxyde métallique est du dioxyde de titane.

6. Procédé selon la revendication 4 ou la revendication 5, dans lequel la couche d'oxyde métallique est appliquée par pyrolyse par pulvérisation ou revêtement par centrifugation d'une solution de précurseur suivi d'un traitement thermique.

7. Procédé selon la revendication 1 et une quelconque revendication précédente dépendante de la revendication 1, dans lequel les nanoparticules d'oxyde métallique sont sélectionnées parmi un ou plusieurs d'un oxyde de titane, d'alumine ou de zircone.

8. Procédé selon la revendication 7, dans lequel l'oxyde métallique est Al₂O₃.

9. Procédé selon une quelconque revendication précédente dans lequel le précurseur de pérovskite est un halogénure organométallique.

10. Procédé selon une quelconque revendication précédente dans lequel le pourcentage de nanoparticules d'oxyde métallique dans la solution de précurseur contenant le précurseur de pérovskite est 1 à 15 % de préférence 1,5 à 12 % et plus particulièrement 2-7 %.

11. Procédé selon une quelconque revendication précédente dans lequel une fois posée sur une couche de dioxyde, la solution de précurseur est traitée à chaud à une température allant jusqu'à 200 degrés centigrades, de préférence 150 degrés centigrades et de manière encore davantage préférée entre 100 et 120 degrés centigrades.

12. Procédé selon une quelconque revendication précédente dans lequel la couche compacte et le revêtement sont prévus en tant qu'une seule couche intégrale.
